# EUROPÄISCHE PATENTSCHRIFT

(11) **EP 0 770 701 B1**
(45) Veröffentlichungstag und Bekanntmachung des Hinweises auf die Patenterteilung: **17.04.2002**
(21) Anmeldenummer: 96113280.0
(22) Anmeldetag: 20.08.1996
(51) Int. Cl.: C23C 14/35, H01J 37/34

(54) **Verfahren zur Herstellung eines Targets für die Sputterkathode einer Vakuumbeschichtungsanlage mittels einer Giesstechnik**
Process for the manufacture by casting of a sputtering cathode of a vacuum coating apparatus
Procédé de production d'une cible pour cathode de pulvérisation dans un appareil de dépôt vide par coulage

(30) Priorität: 27.09.1995 DE 19535894
(43) Veröffentlichungstag der Anmeldung: 02.05.1997
(73) Patentinhaber: Unaxis Materials Deutschland GmbH, 63450 Hanau (DE)
(72) Erfinder: Wollenberg, Norbert, 63538 Grosskrotzenburg (DE)
(74) Vertreter: Bockhorni, Josef, Dipl.-Ing.

(56) Entgegenhaltungen:
- EP-A- 0 512 456
- DE-A- 4 301 516
- DE-C- 4 410 466
- US-A- 4 657 654
- US-A- 5 066 381
- PATENT ABSTRACTS OF JAPAN vol. 007, no. 281 (C-200), 15.Dezember 1983 & JP-A-58 157968 (KOUJIYUNDO KAGAKU KENKYUSHO:KK), 20.September 1983,

## Beschreibung

Die Erfindung betrifft ein Verfahren zur Herstellung einer Targeteinheit für die Sputterkathode einer Vakuumbeschichtungsanlage.

Um eine bessere Kühlung bei der Kathodenzerstäubung von Targets zu erreichen, ist es bekannt (DE-A-36 03 646), den plattenförmig ausgeformten Targetwerkstoff mit Hilfe von Klemmen oder Pratzen auf der Kathodengrundplatte, die im allgemeinen mit einer Wasserkühlung versehen ist, fest zu verbinden.

Bekannt ist weiterhin eine Targetanordnung für eine Kathodenzerstäubungsanlage mit geschlossener Kathodengestalt, mit einem Targetkörper, der mittels einer lösbaren Befestigungseinrichtung an ein Kühlsystem ankoppelbar ist, wobei zwischen dem Targetkörper und dem Kühlsystem eine Trennmembran vorgesehen ist, die zum einen mit dem Kühlsystem und zum anderen mit dem Targetkörper durch getrennte Befestigungseinrichtungen in Verbindung steht (DE-A-42 01 551). Eine solche Targetanordnung ist aus DE-A-4 301 516 bekannt.

Bekannt ist auch eine Zerstäubungskathode (DE-A-42 01 551), die nach dem Magnetronprinzip arbeitet, mit einem Kathodenkörper, der mit einem eine Zerstäubungsfläche und eine Umfangsfläche aufweisenden Target ausgestattet ist, wobei hinter dem Target ein Magnetsystem mit ineinander liegenden Polen entgegengesetzter Polarität zur Erzeugung von magnetischen Feldlinien vorgesehen ist, die aus dem Target austreten und nach Durchlaufen von bogenförmigen Bahnen wieder in das Target eintreten, wobei die außerhalb der Erosionszone liegenden Randbereiche des Targets von einem parallel zur Zerstäubungsfläche verlaufenden, einen Innenrand aufweisenden Fortsatz der Dunkelraumabschirmung überdeckt sind. Die Dunkelraumabschirmung ist elektrisch schwimmend angeordnet und durch einen Spalt vom Target getrennt, der derart groß ist, daß zwischen Target und Dunkelraumabschirmung kein Plasma zünden kann, so daß nur das frei liegende Target zerstäubt wird.

Der vorliegenden Erfindung liegt die Aufgabe zugrunde, ein Target besonderer Größe zu schaffen, das sich zum einen insbesondere zum Beschichten von großflächigen Substraten, z.B. Fensterscheiben, eignet und zum anderen preiswert herstellbar ist. Insbesondere soll das abgenutzte Target mit vergleichsweise geringem Aufwand wieder aufarbeitbar sein und eine besonders rasche Montage bzw. Demontage an der Kathode ermöglichen.

Diese Aufgabe wird gemäß der Erfindung dadurch gelöst, daß ein Verfahren zur Herstellung einer Targeteinheit bereitgestellt wird, bei dem der Rahmen mit einer Vielzahl sich vom Rahmen aus in einer zur Targetebene parallelen Ebene jeweils ein Stück weit sich in das Zerstäubungsmaterial hinein erstreckenden, mit dem Rahmen verbundenen Bolzen, Zungen oder leistenförmigen Vorsprüngen zur Halterung des Zerstäubungsmaterials an den Rahmenteilen versehen ist, wobei die Bolzen, Zungen oder Vorsprünge vom Zerstäubungsmaterial umschlossen sind.

Weitere Einzelheiten und Merkmale sind in dem Patentanspruch näher gekennzeichnet.

Die Erfindung läßt die verschiedensten Ausführungsmöglichkeiten zu; eine davon ist in den anhängenden Zeichnungen näher dargestellt, und zwar zeigen:
- Figur 1: das Endstück eines Rahmens in perspektivischer Ansicht und im Querschnitt,
- Figur 2: das Endstück gemäß Figur 1, jedoch aufgefüllt mit dem Targetwerkstoff und

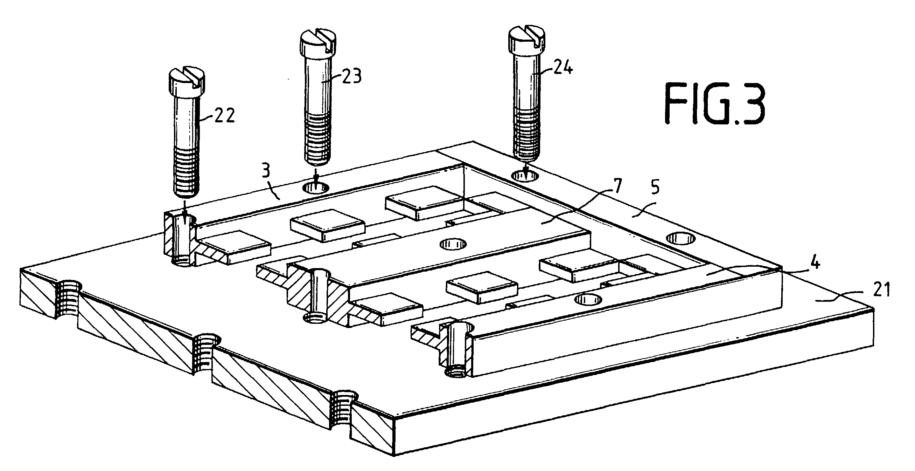

- Figur 3: die Rahmenteile des Targets, die mit einer Edelstahlplatte zum Ausgießen mit Targetwerkstoff fest verbunden.

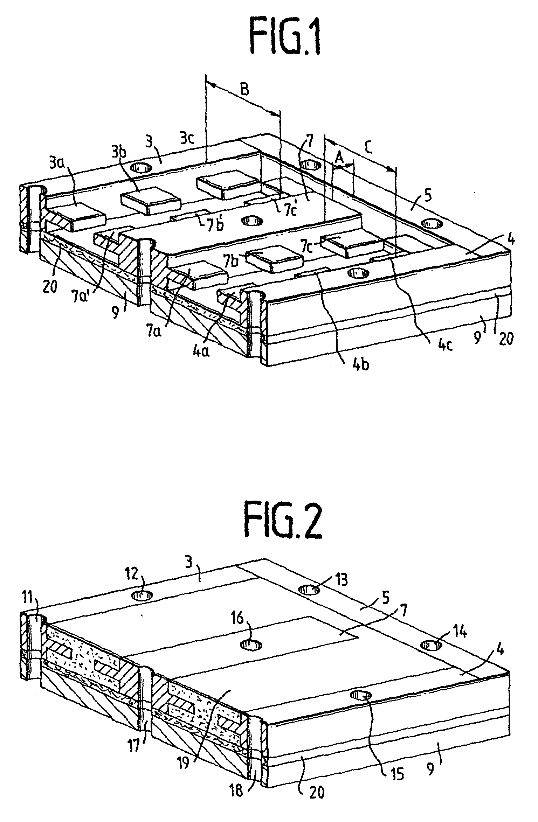

Das Target besteht aus vier Profilzuschnitten 3, 4, 5, ..., die alle zusammen einen länglichen, rechteckigen Rahmen bilden und einen kürzer bemessenen Mittelsteg 7, der so zwischen den Rahmenteilen 3, 4, 5, ... angeordnet ist, daß er sich einerseits parallel zu den beiden Seitenteilen 3, 4 erstreckt und andererseits Spalte A, ... mit den beiden Kopfteilen 5, ... bildet. Die seitlichen Rahmenteile 3, 4 und auch die beiden Kopfteile 5, ... sind jeweils mit seitlich abstehenden Vorsprüngen bzw. Zungen 3a, 3b, ..., 4a, 4b, ... versehen, die sich bis in die vom Mittelteil und den Seitenteilen gebildeten Zwischenräume B bzw. C erstrecken. Auch das Mittelteil 7 ist mit sich in die Zwischenräume B, C erstreckenden Zungen 7a, 7b, ... bzw. 7a', 7b', ... versehen, die sich bis in die Zwischenräume B, C erstrecken. Das in Figur 2 dargestellte Target wird mit der Kathodengrundplatte 9 der Kathode verschraubt, wozu die Rahmenteile 3, 4, 5, ..., 7 mit einer Vielzahl von Bohrungen 11 bis 18 versehen sind. Um den Wärmeübergang vom die Zwischenräume A, B, C, ... auffüllenden Targetwerkstoff zur Rückenplatte bzw. Kathodengrundplatte 9 zu verbessern, ist eine Folie 20 aus die Wärme gut leitendem Werkstoff zwischen dem Targetwerkstoff 19 bzw. den Rahmenteilen 3, 4, 5, ..., 7 eingelegt.

Zur Herstellung des Targets werden zunächst die Rahmenteile 3, 4, 5, ..., 7 auf einer Edelstahlplatte 21 mit Hilfe von Schrauben 22, 23, 24, ... aufgeschraubt, derart, daß die Rahmenteile spaltenfrei auf der Oberseite der Platte 21 aufliegen. Danach werden Edelstahlplatte 21 und Rahmenteile auf eine Temperatur erwärmt, die etwa der Schmelztemperatur des Targetwerkstoffs 19 entspricht; danach wird dann das aufgeschmolzene Targetmaterial 19 von oben her in die Zwischenräume A, B, C, ... eingegossen, bis der Schmelzenspiegel diese Zwischenräume A, B, C, ... vollständig ausfüllt. Nach dem Gießvorgang und dem Erkalten des Targetwerkstoffs 19 und der Platte 21 können die Schrauben 22, 23, 24, ... gelöst und der Rahmen zusammen mit dem Targetwerkstoff 19 als eine einzige kompakte Einheit von der Platte 21 abgehoben werden und anschließend mit der Kathodengrundplatte verschraubt werden (wie dies Figur 2 zeigt).

Es ist klar, daß die Werkstoffe für die Platte 21 und die Rahmenteile (3, 4, 5, ...) so gewählt werden müssen, daß sich der Targetwerkstoff 19 nicht mit dem Werkstoff der Rahmenteile und der Platte 21 untrennbar verbindet.

## Patentansprüche

1. Verfahren zur Herstellung einer Targeteinheit für die Sputterkathode einer Vakuumbeschichtungsvorrichtung mit einem das Zerstäubungsmaterial (19) zumindestens teilweise umschließenden Rahmen (3,4,5,...7) zur Halterung des Zerstäubungsmaterials (19) auf der Kathodenrückenplatte (9) mit einer Vielzahl sich vom Rahmen (3,4,5,...7) aus in einer zur Targetebene parallelen Ebene jeweils ein Stück weit in das Zerstäubungsmaterial (19) hinein erstreckenden, mit den Rahmenteilen (3,4,5,...7) fest verbundenen Bolzen, Zungen oder Vorsprüngen (3a,3b,...4a,4b,...7a,7b...) einen ersten Verfahrensschritt umfassend, in dem der Rahmen (3,4,5,...7) aus einem metallischen Werkstoff, vorzugsweise aus Kupfer, auf eine aufheizbare, horizontal ausgerichtete ebene Platte (21), vorzugsweise aus Edelstahl, aufgelegt und mit dieser verschraubt oder verpratzt wird und in einem zweiten Verfahrenssschritt die vom Rahmen (3,4,5,...7) und der Platte (21) gebildete schalenförmige Vertiefung (A,B,C) mit aufgeschmolzenem Zerstäubungsmaterial, beispielsweise mit flüssigem Zinn, ausgegossen wird, bis der Schmelzenspiegel die Oberseite des Rahmens (3,4,5, ... 7) erreicht hat, woraufhin in einem dritten Verfahrensschritt die Schmelze gleichmäßig auf Raumtemperatur abgekühlt und anschließend der Rahmen (3,4,5,...7) mit dem erstarrten Zerstäubungsmaterial von der Edelstahlplatte (21) abgelöst und mit der Kathodenrückenplatte (9) verschraubt wird.

## Claims

1. Method of manufacturing a target unit for the sputtering cathode of a vacuum coating apparatus including a frame (3,4,5,...7), which at least partially encloses the sputtering material (19), for mounting the sputtering material (19) on the cathode rear plate (9) with a plurality of pegs, tongues or projections (3a,3b....4a,4b....7a,7b...), which are firmly connected to the frame portions (3,4,5,....7) and extend a way into the sputtering material (19) in a plane parallel to the target plane, including a first method step in which the frame (3,4,5,....7) of a metallic material, preferably copper, is placed on a heatable, horizontally aligned flat plate (21), preferably of stainless steel, and is screwed or secured by brackets to it and in a second method step the dish-shaped recess (A,B,C), defined by the frame (3,4,5,....7) and the plate (21) is filled with molten sputtering material, for instance with liquid tin, until the molten material level has reached the upper surface of the frame (3,4,5,....7), whereafter in a third method step the molten material is cooled uniformly to room temperature and the frame (3,4,5,....7) is then released with the solidified sputtering material from the stainless plate (21) and is screwed to the cathode rear plate (9).

## Revendications

1. Procédé pour fabriquer une unité formant cible pour la cathode de pulvérisation d'un dispositif de dépôt sous vide comportant un cadre (3,4,5,...7) entourant au moins partiellement le matériau de pulvérisation (19), pour retenir le matériau de pulvérisation (19) sur la plaque arrière (9) de la cathode à l'aide d'une multiplicité de goujons, languettes ou parties saillantes (3a,3b...4a,4b ...7a,7b...) qui s'étendent sur une certaine étendue à l'intérieur du matériau de pulvérisation (19), à partir du cadre (3,4,5,...7), dans un plan parallèle au plan de la cible, et sont reliés de façon fixe aux éléments (3,4,5,...7) du cadre, comprenant une première étape de procédé, lors de laquelle on place le cadre (3,4,5,...7) formé d'un matériau métallique, de préférence du cuivre, sur une plaque plane (21) pouvant être chauffée et disposée horizontalement, réalisée de préférence en acier spécial et vissée ou chevillée dans cette plaque et, lors d'une seconde étape de procédé, on coule dans le renfoncement en forme de coque (A,B,C) formé par le cadre (3,4,5,...7) et la plaque (21), un matériau de pulvérisation pouvant être fondu, par exemple de l'étain liquide, jusqu'à ce que la surface de la masse fondue ait atteint le côté supérieur du cadre (3,4,5,...7), à la suite de quoi, lors d'une troisième étape de procédé, on refroidit uniformément la masse fondue à la température ambiante et ensuite on détache le cadre (3,4,5,...7) pourvu du matériau de pulvérisation solidifié, de la plaque d'acier spécial (21) et on le visse sur la plaque arrière de cathode (9).
